# EUROPEAN PATENT APPLICATION

(11) **EP 4 637 297 A1**
(43) Date of publication of application: **22.10.2025**
(21) Application number: 25168501.2
(22) Date of filing: 04.04.2025
(51) Int. Cl.: H10D 84/03, H10D 84/01, H10D 30/01, H01L 23/485, H01L 23/528, H10D 84/83, H10D 88/00, H10D 84/85, H01L 21/768, H10D 64/23

(54) **A METHOD FOR FORMING AN INTEGRATED CIRCIUT DEVICE AND AN INTEGRATED CIRCUIT DEVICE**

(30) Priority: 19.04.2024 EP 24171409
(71) Applicant: Imec VZW, 3001 Leuven (BE)
(72) Inventor: GUPTA, Anshul, 3000 Leuven (BE); MERTENS, Hans, 3000 Leuven (BE); HORIGUCHI, Naoto, 3000 Leuven (BE); VEGA GONZALEZ, Victor Hugo, 3001 Heverlee (BE); HELLINGS, Geert, 1500 Halle (BE)
(74) Representative: AWA Sweden AB

(57) **Abstract**

A method for forming an integrated circuit device (1), the method comprising:
forming a stack of field effect transistors (60), FETs, comprising a bottom FET (61) and a top FET (62);
forming a first trench (5) underneath the bottom FET (61);
forming a first hole (10), between the first trench (5) and a first source/drain region (51) of the bottom FET (61);
forming a second hole (20), between the first hole (10) and a contact (81) of a contact layer (80) arranged above the top FET (62);
performing a first metal deposition to fill the first hole (10); the second hole (20); and part of the first trench (5), with metal;
recessing the metal deposited in the first metal deposition;
forming an isolation layer (92) below the recessed metal;
performing a second metal deposition to fill the first trench (5) with metal, thereby forming a first backside wiring line (71) in the first trench (5).

## Description

### TECHNICAL FIELD

The present inventive concept relates, in general, to a method for forming an integrated circuit device and an integrated circuit device.

### BACKGROUND

To enable more area- and power-efficient circuits, vertical semiconductor device structures are receiving increasing attention as an alternative to traditional planar semiconductor devices. One notable example is stacked transistor devices comprising a complementary pair of field effect transistors (FETs) stacked on top of each other, i.e. a p-type FET (pFET) on top of a n-type FET (nFET) or vice versa. A complementary pair of FETs stacked on top of each other is called a complementary FET (CFET).

### SUMMARY

It is an objective of the present inventive concept to facilitate a compact integrated circuit device. In particular, it is an objective to enable a compact CFET. It is an objective of the present inventive concept to facilitate a high density of integrated circuit devices, e.g. a high density of CFETs.

It is a further objective of the present inventive concept to facilitate self-alignment between parts of the integrated circuit device.

It is a further objective of the present inventive concept to enable a high-quality integrated circuit device.

It is a further objective of the present inventive concept to facilitate easy and/or low-cost manufacturing of the integrated circuit device.

It is a further objective of the present inventive concept to facilitate flexible production of integrated circuit devices.

These and other objectives of the inventive concept are at least partly met by the invention as defined in the independent claims. Preferred embodiments are set out in the dependent claims.

According to a first aspect there is provided a method for forming an integrated circuit device, the method comprising:
forming a stack of field effect transistors, FETs, the stack of FETs comprising a bottom FET and a top FET, the bottom FET comprising at least a first source/drain region, the top FET comprising at least a first source/drain region arranged above the first source/drain region of the bottom FET;
forming a first trench underneath the bottom FET;
forming a first hole, extending between a top portion of the first trench and the first source/drain region of the bottom FET;
forming a second hole, the second hole extending between a top portion of the first hole and a contact of a contact layer and being laterally spaced apart from the first source/drain region of the top FET, the contact layer being arranged above the top FET;
performing a first metal deposition to fill the first hole; the second hole; and at least part of the first trench, with metal;
recessing the metal deposited in the first metal deposition, the recessed metal forming an electrical connection extending between the first source/drain region of the bottom FET and the contact of the contact layer, a bottom portion of the recessed metal being arranged within the first hole;
forming an isolation layer below the bottom portion of the recessed metal;
performing a second metal deposition to fill the first trench with metal, such that the metal of the second metal deposition forms a first backside wiring line in the first trench, the first backside wiring line being electrically isolated from the electrical connection extending between the first source/drain region of the bottom FET and the contact of the contact layer, by the isolation layer.

Relative spatial terms such as "top", "bottom", "lower", "vertical", "stacked on top of", are herein to be understood as denoting locations or directions within a frame of reference of the integrated circuit device. In particular, the terms may be understood in relation to a normal direction to a substrate on which the stack of FETs is formed, or equivalently in relation to a bottom-up direction of the stack of FETs. Correspondingly, terms such as "lateral" and "horizontal" are to be understood as locations or directions parallel to the substrate.

A first direction may be understood as a direction in which the current of the FETs flows. A second direction may be understood as a direction transverse to the first direction. A third direction may be understood as the vertical or bottom-up direction. The first and second directions may be parallel to the substrate. The third direction may be normal to the substrate.

The stack of FETs may be arranged on a substrate. The stack of FETs may be a stack of FETs among a plurality of stacks of FETs.

The bottom FET may be a pFET and the top FET may be a nFET, or vice versa. Thus, the stack of FETs may be a CFET. Alternatively, both the bottom FET and the top FET may be pFETs. Alternatively, both the bottom FET and the top FET may be nFETs.

Each of the bottom FET and the top FET may comprise at least one channel layer for charge transport. The channel layers may be part of a stack of layers forming a fin. The fin may comprise two opposing lateral side faces, two opposing lateral end faces, and a top face. A bottom face of the fin may be facing the substrate. Each channel layer may comprise a semiconductor, e.g. silicon. The substrate may comprise a semiconductor. The substrate may be e.g. a silicon substrate or a silicon-on-insulator substrate.

Each of the bottom FET and the top FET may comprise two source/drain regions, being arranged at opposite ends of the at least one channel layer, i.e. at the opposing lateral end faces of the fin. Thus, the first source/drain region may be a source/drain region at one of the ends of the channel layer of the bottom FET. Each source/drain region may comprise a semiconductor, e.g. silicon. Each source/drain region may be doped, e.g. p doped when belonging to a pFET or n doped when belonging to a nFET.

Each of the bottom FET and the top FET may comprise a gate configured to control the charge transport through the at least one channel layer. The gate may be e.g. a gate-all-around extending around the channel layers or a tri-gate at three sides of the channel layers.

The stack of FETs may be arranged within a device isolation layer. Thus, the stack of FETs may be laterally surrounded by device isolation material. Said device isolation layer may be called zero-level interlayer dielectric (ILD0). The device isolation layer may electrically isolate one stack of FETs from another stack of FETs. The device isolation layer may comprise electrically insulating material, e.g. dielectric material. The device isolation layer may comprise SiO₂ and/or SiOC and/or Si₃N₄**.**

The first trench may be, at least partially, arranged in the device isolation layer. The first trench may extend in parallel with the channel layers of the bottom FET. Thus, the first trench may extend in the first direction. The first trench may be longer than the channel layers of the bottom FET. The first trench may extend also underneath the bottom FET of a further stack of FETs. Thus, as the metal of the second metal deposition forms the first backside wiring line in the first trench, the stack of FETs and said further stack of FETs may both be arranged along the first backside wiring line. The first trench may be wider than the channel layers of the bottom FET. Forming the first trench may comprise etching a bottom portion of the fin. Said bottom portion of the fin may be laterally surrounded by the device isolation layer. Additionally, or alternatively, forming the first trench may comprise etching the device isolation layer itself.

The first hole may be, at least partially, arranged in the device isolation layer. The first hole may have the same width as the trench. Thus, in the second direction, the expanse of the first hole and the trench may be the same. In the first direction (the direction of the current flow), the expanse of the first hole may be smaller than the expanse of the trench. In the first direction, the expanse of the first hole may be the same or smaller than the expanse of the first source/drain region of the bottom FET. Forming the first hole may comprise etching a bottom portion of the fin. Additionally, or alternatively, forming the first hole may comprise etching the device isolation layer itself.

The second hole may be, at least partially, arranged in the device isolation layer. In the first direction (the direction of the current flow), the expanse of the second hole may be the same as or smaller than the expanse of the first hole. In the second direction, the expanse of the second hole may be smaller than the expanse of the first hole. Forming the second hole may comprise etching the device isolation layer.

The portion of the recessed metal that is arranged within the first hole may form a metal contact to the first source/drain region of the bottom FET. Such a metal contact may be referred to as M0AB.

The portion of the recessed metal that is arranged within the second hole may form a via.

As mentioned, the recessed metal forms an electrical connection extending between the first source/drain region of the bottom FET and the contact of the contact layer. Such a metal contact may be referred to as MOAT. In other words, the first source/drain region of the bottom FET may be connected to the contact of the contact layer (MOAT) by the recessed metal. In other words, the first source/drain region of the bottom FET may be connected to the contact of the contact layer (MOAT) by the metal contact to the first source/drain region of the bottom FET (MOAB) and the via.

As mentioned, the first backside wiring line is electrically isolated by the isolation layer, from the electrical connection extending (vertically) between the first source/drain region of the bottom FET and the contact of the contact layer. Thus, the first backside wiring line is electrically isolated from the metal contact to the first source/drain region of the bottom FET (MOAB). Accordingly, the first backside wiring line may extend (horizontally) below the metal contact to the first source/drain region of the bottom FET (M0AB), without connecting to it. Instead, the first backside wiring line may connect to a first source/drain region of a bottom FET of another stack of FETs, further along the first backside wiring line.

The method facilitates a compact integrated circuit device and/or a high density of stacks of FET since the first backside wiring line may extend below the metal contact to the first source/drain region of the bottom FET (M0AB), without connecting to it.

In particular, the method facilitates the first backside wiring line being self-aligned with the metal contact to the first source/drain region of the bottom FET (MOAB). Thus, in the second direction, the footprint of the first backside wiring line may overlap with the footprint of the metal contact to the first source/drain region of the bottom FET (MOAB).

Accordingly, the first hole may be self-aligned with the first trench. Further, the trench may be self-aligned with the stack of FETs. Accordingly, the first hole may be self-aligned with the stack of FETs.

A consequence of the first hole being self-aligned with the first trench may be that a first sidewall of the first hole and a first sidewall of the first trench are arranged in a same first plane, e.g. in a same first plane orthogonal to the second direction. Similarly, a second sidewall of the first hole and a second sidewall of the first trench may be arranged in a same second plane, e.g. in a same second plane orthogonal to the second direction.

In a cross-section perpendicular to the first direction (i.e. perpendicular to a current flow direction of the stack of FETs), the first hole and the first trench may be arranged on a common central axis. In said cross-section, the respective first sidewalls of the first hole and the first trench may be the left sidewalls and the respective second sidewalls of the first hole and the first trench may be the right sidewalls.

It should be noted that, in the finished integrated circuit device, a sidewall of the metal in the first hole and a sidewall of the metal in the first trench may not necessarily be arranged in a same plane. As will be discussed below, the isolation layer may be formed by conformal deposition. This may result in deposition on the sidewalls of the first trench prior to the second metal deposition in the first trench. In such a situation, the sidewalls of the metal in the first trench may not lie in the same plane as the sidewalls of the first trench. However, it may still hold true that in a cross-section perpendicular to the first direction (i.e. perpendicular to a current flow direction of the stack of FETs), the metal in the first hole and the metal in the first trench are arranged on a common central axis. Self-alignment minimizes misalignment errors, which in turn further facilitates a compact integrated circuit device and/or a high density of stacks of FETs.

In view of the above, the method facilitates a high-quality integrated circuit device. As mentioned, misalignment errors may be small. This in turn facilitates improved performance. For example, parasitic capacitances may be well controlled when misalignment errors are small.

Further, the method facilitates easy and/or low-cost manufacturing of an integrated circuit device. To exemplify, self-alignment may reduce the number of patterning steps needed.

As previously mentioned, the stack of FETs may be a stack of FETs among a plurality of stacks of FETs. Similarly, the first backside wiring line may be one backside wiring line among a plurality of backside wiring lines and the contact may be one contact among a plurality of contacts.

The first backside wiring line may be part of a backside wiring layer. The backside wiring layer may be called backside power delivery network. A backside wiring line may alternatively be called backside power rail.

The backside wiring layer may comprise, in addition to the first backside wiring line, further backside wiring lines. Such a further backside wiring line may connect to a source/drain region of a FET laterally spaced apart from the bottom FET, e.g. to the bottom FET of a stack of FETs laterally spaced apart from the stack of FETs.

The contact layer may comprise further contacts, in addition to the contact that connects to the first source/drain region of the bottom FET by the recessed metal. Such a further contact may connect to the first source/drain region of the top FET of the stack of FETs or to a source/drain region of the top FET of another stack of FETs. Accordingly, in the case where there is a plurality of stacks of FETs, one contact of the contact layer may be connected a source/drain region of a bottom FET, by the recessed metal, while another contact of the contact layer is connected, e.g. directly connected, to a source/drain region of a top FET.

In view of the above, the method facilitates flexible production of integrated circuit devices. In particular, the method facilitates flexible signal routing designs wherein contacts of the contact layer may be connected either to a bottom FET or a top FET.

In the following, the first and second hole will be discussed. As mentioned, the second hole is laterally spaced apart from the first source/drain region of the top FET. Thus, when the second hole is filled with metal it may form an electrical connection which bypasses the source/drain region of the top FET.

A first side portion of the first hole may be arranged on a same vertical axis as the first source/drain region of the bottom FET and the first source/drain region of the top FET; and a second side portion of the first hole may be arranged on a vertical axis laterally spaced apart from the first source/drain region of the top FET. Further, the second hole may be formed at the second side portion of the first hole. Accordingly, the production of an electrical connection which bypasses the source/drain region of the top FET is facilitated. The second hole may be etched from the second side portion of the first hole, vertically along the axis laterally spaced apart from the first source/drain region of the top FET.

The method may be configured such that the first hole:
exposes at least part of a bottom side of the first source/drain region of the bottom FET; and
exposes at least part of a lateral side of the first source/drain region of the bottom FET.

In other words, the metal contact (MOAB) to the first source/drain region of the bottom FET may connect to both to the bottom side of the first source/drain region of the bottom FET and to the lateral side of the first source/drain region of the bottom FET.

When the metal contact (MOAB) to the first source/drain region of the bottom FET connects both the bottom side of the first source/drain region and the lateral side of the first source/drain region, the resistance of said metal contact may be small. For example, a large contact area between the metal contact and the first source/drain region of the bottom FET may be provided. Thus, the contact resistance may be small.

The above may be achieved e.g. by etching the first hole to a level above the bottom side of the first source/drain region of the bottom FET.

The act of forming the isolation layer on the bottom portion of the recessed metal may, advantageously, be performed by conformal deposition. Thereby, the electrical isolation between the recessed metal and the first backside wiring line may be good. For example, even if the recessed metal is not completely aligned with the bottom of the trench, the conformal deposition may effectively isolate the recessed metal from the first backside wiring line. An example of conformal deposition is Atomic Layer Deposition (ALD).

The act of forming the stack of FETs may comprise forming a fin, the fin comprising a bottom portion and a top portion, wherein channel layers of the bottom and top FETs are arranged in the top portion of the fin. Further, the first trench may be formed by etching the bottom portion of the fin. This facilitates self-alignment between the first backside wiring line and the channel layers of the bottom and top FETs which, in turn, facilitates a compact device. Further, easy and/or low-cost contacting between the first backside wiring line and FETs is facilitated due to the self-alignment, e.g. due to few patterning steps being needed.

The fin may be formed such that the bottom portion of the fin is wider than the top portion of the fin. Thus, the trench may be wider than the channel layers. This facilitates the formation of an electrical connection which bypasses the source/drain region of the top FET.

As previously mentioned, there may be further FETs, other than the bottom and top FET of the stack of FETs. The method may further comprise:
forming a FET laterally spaced apart from the bottom FET, at a same height as the bottom FET;
forming a second backside wiring line in electrical connection with a source/drain region of the FET laterally spaced apart from the bottom FET.

For example, said act of forming the second backside wiring line may comprise:
forming a second trench underneath the FET laterally spaced apart from the bottom FET;
forming a third hole, extending between a top portion of the second trench and the source/drain region of the FET laterally spaced apart from the bottom FET;
performing a metal deposition to fill the third hole; and at least part of the second trench, with metal.

The FET laterally spaced apart from the bottom FET of the stack of FETs may be a bottom FET of a further stack of FETs. Thus, the backside wiring layer may comprise, in addition to the first backside wiring line, a second backside wiring line which connects to a source/drain region of a bottom FET of a further stack of FETs. It should be understood that the second backside wiring line may be parallel to the first backside wiring line. Additionally, further backside wiring lines may be parallel to the first backside wiring line.

Thus, the first backside wiring line may be electrically isolated from M0AB above while the second wiring line is electrically contacted to M0AB above.

Similarly, any given backside wiring line may extend in the first direction underneath one or more source/drain regions, while being electrically isolated from said source/drain regions, until it reaches a designated source/drain region. At this point, said backside wiring line may be connected to the designated source/drain region.

According to a second aspect, there is provided an integrated circuit device, the integrated circuit device comprising:
a stack of field effect transistors, FETs, the stack of FETs comprising a bottom FET and a top FET, the bottom FET comprising at least a first source/drain region, the top FET comprising at least a first source/drain region arranged above the first source/drain region of the bottom FET;
a first trench underneath the bottom FET, the first trench being filled (e.g. at least partially filled) with metal to form a backside wiring line;
a first hole, extending between a top portion of the first trench and the first source/drain region of the bottom FET;
a second hole, the second hole extending between a top portion of the first hole and a contact of a contact layer and being laterally spaced apart from the first source/drain region of the top FET, the contact layer being arranged above the top FET;
an electrical connection between the first source/drain region of the bottom FET and the contact of the contact layer, the electrical connection comprising metal arranged to fill the second hole and at least part of the first hole, the metal of the electrical connection extending from the contact of the contact layer to an isolation layer arranged within the first hole;
wherein the first backside wiring line is electrically isolated from the electrical connection between the first source/drain region of the bottom FET and the contact of the contact layer, by the isolation layer;
wherein the first hole is self-aligned with the first trench.

As discussed above, a consequence of the first hole being self-aligned with the first trench may be that, in a cross-section perpendicular to a current flow direction of the stack of FETs, the metal in the first hole and the metal in the first trench are arranged on a common central axis.

Thus, phrased differently, there is provided an integrated circuit device, the integrated circuit device comprising:
a stack of field effect transistors, FETs, the stack of FETs comprising a bottom FET and a top FET, the bottom FET comprising at least a first source/drain region, the top FET comprising at least a first source/drain region arranged above the first source/drain region of the bottom FET;
a first trench underneath the bottom FET, the first trench being filled (e.g. at least partially filled) with metal to form a backside wiring line;
a first hole, extending between a top portion of the first trench and the first source/drain region of the bottom FET;
a second hole, the second hole extending between a top portion of the first hole and a contact of a contact layer and being laterally spaced apart from the first source/drain region of the top FET, the contact layer being arranged above the top FET;
an electrical connection between the first source/drain region of the bottom FET and the contact of the contact layer, the electrical connection comprising metal arranged to fill the second hole and at least part of the first hole, the metal of the electrical connection extending from the contact of the contact layer to an isolation layer arranged within the first hole;
wherein the first backside wiring line is electrically isolated from the electrical connection between the first source/drain region of the bottom FET and the contact of the contact layer, by the isolation layer;
wherein, in a cross-section perpendicular to a current flow direction of the stack of FETs, the metal in the first hole and the metal in the first trench are arranged on a common central axis.

An integrated circuit device according to the second aspect may have the same advantages, or similar advantages, as the advantages described in conjunction with the first aspect.

The integrated circuit device may be configured such that:
a first side portion of the first hole is arranged on a same vertical axis as the first source/drain region of the bottom FET and the first source/drain region of the top FET; and
a second side portion of the first hole is arranged on a vertical axis laterally spaced apart from the first source/drain region of the top FET.

The integrated circuit device may be configured such that the second hole is arranged at the second side portion of the first hole.

The integrated circuit device may be configured such that the first hole:
exposes at least part of a bottom side of the first source/drain region of the bottom FET; and
exposes at least part of a lateral side of the first source/drain region of the bottom FET.

The integrated circuit device may further comprise
a FET laterally spaced apart from the bottom FET, arranged at a same height as the bottom FET;
a second backside wiring line in electrical connection with a source/drain region of the FET laterally spaced apart from the bottom FET.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figs 1 a-b illustrate an integrated circuit device
Figs 2 a-f illustrate a method for forming an integrated circuit device
Fig. 3 illustrates an integrated circuit device during production
Fig. 4 illustrates an integrated circuit device during production
Fig. 5 illustrates an integrated circuit device during production
Fig. 6 illustrates an integrated circuit device during production

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

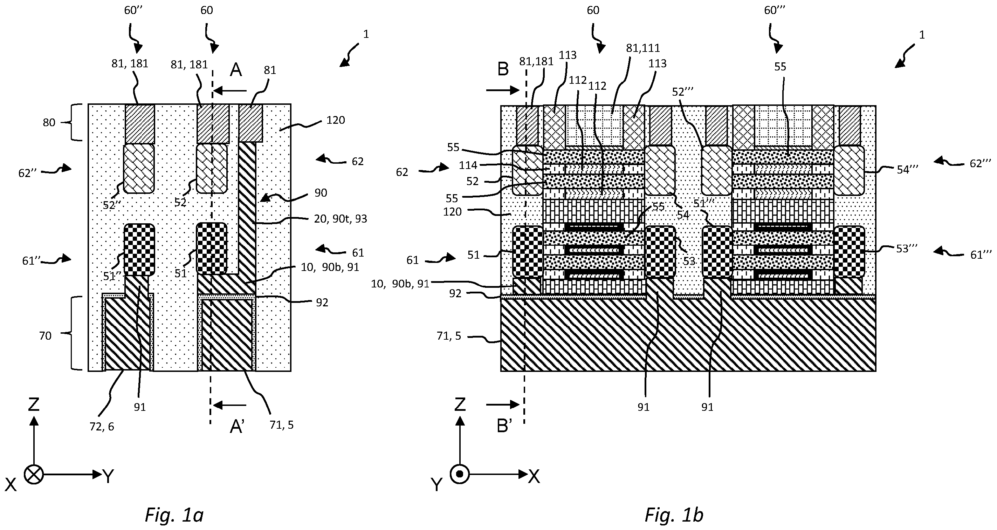

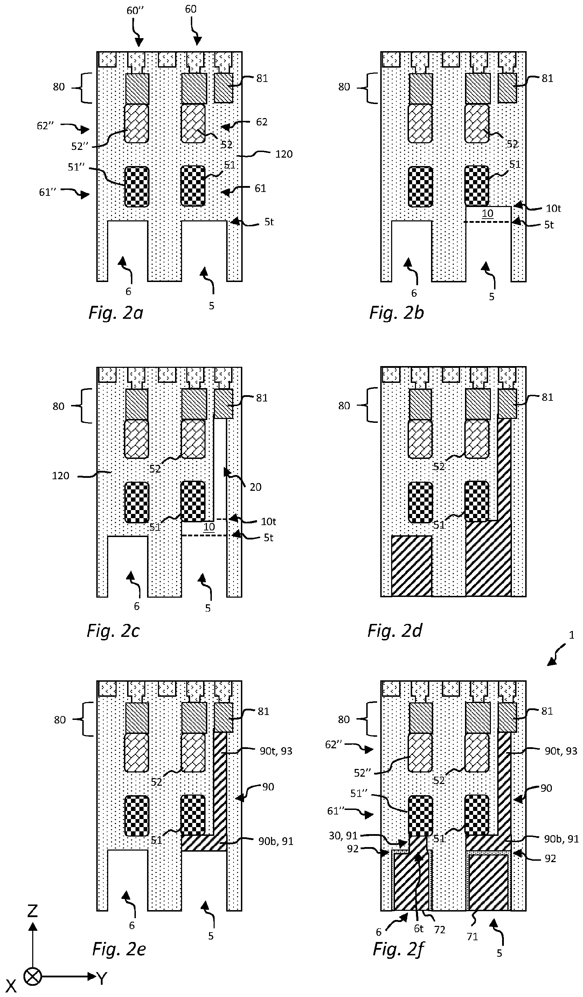

Figs. 1a-b illustrate an integrated circuit device 1, in particular a device comprising stacked transistors such as a CFET device. In the following, various features of the integrated circuit device 1 will be discussed. The formation of the integrated circuit device 1 will be discussed further in conjunction with Fig. 2a-f.

Axes X, Y and Z indicate a first direction, a second direction transverse to the first direction, and a vertical or bottom-up direction, respectively. The X-and Y-direction may in particular be referred to as lateral or horizontal directions in that they are parallel to a main plane of a substrate 4. The Z-direction is parallel to a normal direction to the substrate 4.

Fig. 1a and Fig. 1b show respective cross-sectional views of the integrated circuit device 1 taken along vertical planes B-B' (parallel to the YZ-plane) and A-A' (parallel to the XZ plane).

The illustrated integrated circuit device 1 comprises three stacks of FETs 60, referred to as first stack of FETs 60, second stack of FETs 60", and third stack of FETs 60'''. The invention will hereinafter be exemplified by the first stack of FETs 60. In the illustration, the second stack of FETs 60" is laterally spaced apart, in the negative Y-direction, from the first stack of FETs 60; and the third stack of FETs 60‴ is laterally spaced apart, in the X-direction, from the first stack of FETs 60.

As illustrated, the first stack of FETs 60 comprises a bottom FET 61 and a top FET 62. The illustrated bottom 61 and top 62 FET each comprises two channel layers, as seen in Fig. 1b. However, any number of channel layers 55 is possible. The bottom FET 61 comprises a first source/drain region 51 and a second source/drain region 53, arranged at opposite ends of the channel layers 55 of the bottom FET 61. The top FET 62 comprises a first source/drain region 52 and a second source/drain region 54, arranged at opposite ends of the channel layers 55 of the top FET 62. Thus, in the illustration, the current flows in the X-direction.

As illustrated, the channel layers 55 and source/drain regions of the second 60" and third 60‴ stacks of FETs may be configured analogously to the first stack of FETs 60.

The illustrated second stack of FETs 60" comprises a first source/drain region 51" and a second source/drain region 53" arranged at opposite ends of the channel layers 55 of the bottom FET 61" of the second stack of FETs 60". The illustrated second stack of FETs 60" comprises a first source/drain region 52" and a second source/drain region 54" arranged at opposite ends of the channel layers 55 of the top FET 62" of the second stack of FETs 60".

The illustrated third stack of FETs 60‴ comprises a first source/drain region 51‴ and a second source/drain region 53‴ arranged at opposite ends of the channel layers 55 of the bottom FET 61‴ of the third stack of FETs 60"'. The illustrated third stack of FETs 60‴ comprises a first source/drain region 52‴ and a second source/drain region 54‴ arranged at opposite ends of the channel layers 55 of the top FET 62‴ of the third stack of FETs 60‴.

Each illustrated channel layer 55 may comprise a semiconductor, e.g. silicon. Each illustrated source/drain region may comprise a semiconductor, e.g. silicon. Each illustrated source/drain region may be doped, e.g. p doped when belonging to a pFET or n doped when belonging to a nFET. Bottom FETs may be pFETs and top FETs may be nFETs, or vice versa. Alternatively, bottom FETs and top FETs may be nFETs. Alternatively, bottom FETs and top FETs may be pFETs.

Each illustrated FET comprises a gate. The gate of a FET may comprise a work function metal (WFM) 112. The WFM 112 may wrap around the channel layers 55 of the FET to form a gate-all-around. A WFM 112 of a pFET may be different from a WFM 112 of a nFET. Thus, in the case of a CFET, the WFM 112 of the top FET may be different from the WFM 112 of the bottom FET. The WFM 112 may be connected to gate fill metal 111. The gate fill metal 111 may form a contact to the WFM 112. Further, gate spacers 113, e.g. comprising electrically isolating material, may be arranged at lateral sides of the gate fill metal 111. Further, inner spacers 114, e.g. comprising electrically isolating material, may be arranged to isolate the gate from source/drain regions. In Fig. 1b, the WFM 112, gate fill metal 111, gate spacers 113, and inner spacers 114 are marked for the top FET 62 of the first stack of FETs 60.

The illustrated stacks of FETs 60, 60", 60‴ are arranged within a device isolation layer 120. The device isolation material may comprise SiO₂ and/or SiOC and/or Si₃N₄**.**

In Figs 1a-b, the integrated circuit device 1 comprises a backside wiring layer 70 below the stacks of FETs 60, 60", 60‴ and a contact layer 80 above the stacks of FETs 60, 60", 60‴.

The illustrated contact layer 80 comprises a plurality of contacts 81. A contact 81 of the contact layer 80 is connected to the first source/drain region 51 of the bottom FET 61 of the first stack of FETs 60 by an electrical connection 90. The electrical connection 90 comprises metal arranged to fill a second hole 20 and at least part of a first hole 10. A bottom portion 90b of the metal of the electrical connection 90 is arranged in the first hole 10 and may be seen as a metal contact 91 (MOAB) to the first source/drain region 51 of the bottom FET 61 of the first stack of FETs 60. A top portion 90t of the metal of the electrical connection 90 is arranged in the second hole 20 and may be seen as a via 93.

The contact layer 80 may, as illustrated, comprise further contacts 81, e.g. for contacting top FETs 62, 62", 62‴ of the stacks of FETs 60, 60", 60"'. As an example, a further contact 81 of the contact layer 80 may be a metal contact 181 to a source/drain region of a top FET 62, 62", 62"'. As another example, a further contact 81 of the contact layer 80 may be a gate fill metal 111 that contacts WFM 112 of a top FET 62, 62", 62‴.

The illustrated backside wiring layer 70 comprises a first backside wiring line 71 and a second backside wiring line 72. The first backside wiring line 71 comprises a first trench 5 underneath the bottom FET 61 of the first stack of FETs 60, the first trench 5 being filled with metal. As seen in Fig. 1b, the first trench 5 extends in the first direction underneath the first stack of FETs 60 and also underneath the second stack of FETs 60". Thus, the first backside wiring line 71 extends in the first direction underneath the first 60 and second 60" stack of FETs.

The first backside wiring line 71 is electrically isolated from the bottom portion 90b of the metal of the electrical connection 90 by an isolation layer 92. Thus, the first backside wiring line 71 does not connect to the metal contact 91 (MOAB) to the first source/drain region 51 of the bottom FET 61 of the first stack of FETs 60. Instead, the first backside wiring line 71 may connect to one or more other metal contacts 91 (MOAB) to a respective source/drain region different from the first source drain region of the bottom FET 61. In Fig. 1b, the first backside wiring line 71 is in electrical connection with the second source/drain region 53 of the bottom FET 61 of the first stack of FETs 60 and with the first source/drain region 51‴ of the bottom FET 61‴ of the third stack of FETs 60"'. Additionally, or alternatively, the first backside wiring line 71 may connect to a via. For example, the first backside wiring line 71 may connect to a via extending downwards from the backside wiring layer 70, or connect to a via extending upwards from the backside wiring layer 70. Such vias may connect to a further wiring layer.

As mentioned, the illustrated backside wiring layer 70 comprises a second backside wiring line 72, in addition to the first backside wiring line 71. The second backside wiring line 72 comprises a second trench 6 underneath the bottom FET 61" of the second stack of FETs 60", the second trench 6 being filled with metal.

In the following, the formation of an integrated circuit device 1, such as e.g. the integrated circuit device 1 of Figs 1a-b, will be discussed in conjunction with Figs 2a-f. Each of Figs 2a-f shows a cross-sectional view of the integrated circuit device 1 taken along vertical plane B-B' indicated in Fig. 1b.

Fig. 2a shows a first trench 5 formed underneath the bottom FET 61 of the first stack of FETs 60. The first trench 5 may be wider than the first source/drain region 51 of the bottom FET 61 of the first stack of FETs 60. The first trench 5 may be wider than the channel layers 55 of the FETs of the first stack of FETs 60. As mentioned before, the first trench 5 may extend also underneath the bottom FET of a further stack of FETs, such as underneath the third stack of FETs 60‴ illustrated in Fig. 1b. Fig. 2a additionally show a second trench 6 formed underneath the bottom FET 61" of the second stack of FETs 60". The second trench 6 may be configured analogously to the first trench 5. The second trench 6 may extend in parallel with the first trench 5. The illustrated stacks of FETs 60, 60" are arranged within a device isolation layer 120. The device isolation material may comprise SiO₂ and/or SiOC. The device isolation layer may be formed by e.g. Plasma-Enhanced Chemical Vapor Deposition (PECVD) or Low-Pressure Chemical Vapor Deposition (LPCVD).

Fig. 2b shows a first hole 10 formed, the first hole 10 extending between a top portion 5t of the first trench 5 and the first source/drain region 51 of the bottom FET 61 of the first stack of FETs 60. As seen in Fig. 2b, the first hole 10 may have the same width as the first trench 5. Thus, in the second direction (Y-direction), the expanse of the first hole 10 and the first trench 5 may be the same. As seen in Fig. 1b, in the first direction (X-direction, the direction of the current flow), the expanse of the first hole 10 may be smaller than the expanse of the first trench 5. In the first direction, the expanse of the first hole 10 may be the same or smaller than the expanse of the first source/drain region 51 of the bottom FET 61 of the first stack of FETs 60.

Fig. 2c shows a second hole 20 formed. The second hole 20 extends between a top portion 10t of the first hole 10 and a contact 81 of a contact layer 80 arranged above the top FET 62 of the first stack of FETs 60. The second hole 20 is laterally spaced apart from the first source/drain region 52 of the top FET 62 of the first stack of FETs 60. In the first direction (X-direction), the expanse of the second hole may be the same as or smaller than the expanse of the first hole. In the second direction (Y-direction), the expanse of the second hole may be smaller than the expanse of the first hole.

Fig. 2d shows metal filling the first hole 10; the second hole 20; and the first trench 5, after being deposited in the first metal deposition.

Fig. 2e shows an electrical connection 90 formed by recessing the metal deposited in the first metal deposition. The metal may be recessed, as illustrated, at least to the top portion 5t of the first trench 5. The electrical connection 90 extends between the first source/drain region 51 of the bottom FET 61 of the first stack of FETs 60 and the contact 81 of the contact layer 80. A bottom portion 90b of the recessed metal is arranged within the first hole 10 and may be seen as a metal contact 91 (MOAB) to the first source/drain region 51 of the bottom FET 61 of the first stack of FETs 60. A top portion 90t of the metal of the electrical connection 90 is arranged in the second hole 20 and may be seen as a via 93.

Fig. 2f shows the finished integrated circuit device 1.

In the following, the first trench 5 of Fig. 2f will be discussed. As seen in the figure, an isolation layer 92 has been formed below the bottom portion 90b of the recessed metal. The isolation layer 92 may comprise SiO₂ and/or SiOC and/or Si₃N₄**.** The isolation layer 92 may be formed by conformal deposition, such as e.g. Atomic Layer Deposition. In Fig. 2f, a second metal deposition, subsequent to the formation of the isolation layer 92, has filled the first trench 5 with metal. Thus, the metal of the second metal deposition forms a first backside wiring line 71 in the first trench 5, the first backside wiring line 71 being electrically isolated from the electrical connection 90.

In the following, the second trench 6 of Fig. 2f will be discussed. As seen in the figure, an isolation layer 92 has been formed also in the second trench 6. For example, the isolation layer 92 of the second trench 6 may be formed at the same time as the isolation layer 92 of the first trench 5. If it is desired to avoid an isolation layer 92 in the second trench 6, the second trench 6 may be masked during deposition of the isolation layer 92 of the first trench 5. Further, in Fig. 2f it is seen that a third hole 30, extending between a top portion 6t of the second trench 6 and the first source/drain region (51") of the bottom FET 61" of the second stack of FETs 60", has been formed. Further, in Fig. 2f it is seen that a third hole 30 and the second trench 6 are filled with metal. Thus, the metal in the second trench 6 forms a second backside wiring line 72. The metal in the third hole 30 may be seen as a metal contact 91 (MOAB) to the first source/drain region 51" of the bottom FET 61" of the second stack of FETs 60". The metal in the third hole 30 and in the second trench 6 may be deposited during the second metal deposition.

It should be understood that the metal of the first metal deposition may also be deposited in the second trench 6. Further, during recessing the metal of the first deposition in the first trench 5, the metal of the first deposition in the second trench 6 may also be recessed. The recessing may last until the second trench 6 is free from metal.

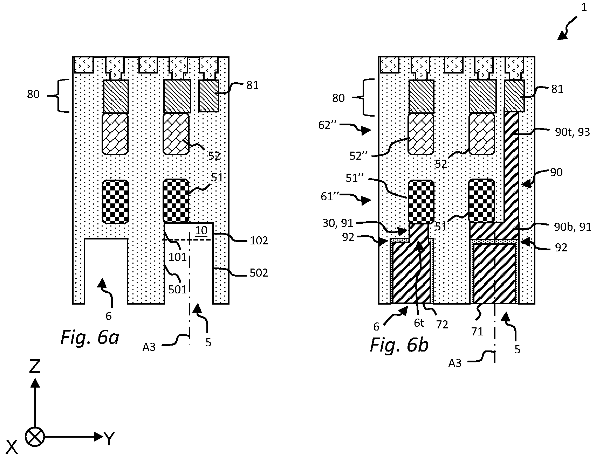

In the following, the self-alignment between the first hole and the first trench as well as the self-alignment between the metal in the first hole and the metal in the first trench will be discussed in conjunction with Fig. 6a-b.

Fig. 6a serves to illustrate self-alignment between the first hole 10 and the first trench 5. Fig. 6a illustrates the integrated circuit device 1 at the same point during production as Fig. 2b. Thus, Fig. 6a illustrates the integrated circuit device 1 immediately after the formation of the first hole 10. In the figure, a first sidewall 101 of the first hole 10 and a first sidewall 501 of the first trench 5 are arranged in a same first plane orthogonal to the second direction (Y direction). Similarly, a second sidewall 102 of the first hole 10 and a second sidewall 502 of the first trench 5 are arranged in a same second plane orthogonal to the second direction. The figure is a cross-section perpendicular to the first direction (X direction), i.e. perpendicular to a current flow direction of the stack of FETs. In the figure, the first hole 10 and the first trench 5 are arranged on a common central axis A3.

Fig. 6b serves to illustrate self-alignment between the metal 90b, in the first hole 10 and the metal 71 in the first trench 5. Fig. 6b illustrates the integrated circuit device 1 at the same point during production as Fig. 2f. Thus, Fig. 6b illustrates the finished integrated circuit device 1.

The figure illustrates that in the finished integrated circuit device 1, a sidewall of the metal 90b in the first hole 10 and a sidewall of the metal 71 in the first trench 5 may not necessarily be arranged in a same plane. However, in the cross-section perpendicular to the first direction that the figure represents (i.e. perpendicular to a current flow direction of the stack of FETs), the metal 90b in the first hole 10 and the metal 71 in the first trench 5 are arranged on a common central axis A3. In the figure, the sidewalls of the metal 71 in the first trench 5 are closer to the common central axis A3 than the sidewalls of the metal 90b in the first hole 10, as a consequence of the conformally deposited isolation layer 92. Further, as a consequence of the conformally deposited isolation layer 92, the width of the metal 71 in the first trench 5 and the width of the metal 90b in the first hole 10 may differ by two times the thickness of the isolation layer 92 (e.g. two times the thickness of the isolation layer 92 measured in the third direction).The metal, deposited in the trenches and/or holes discussed above, may be tungsten (W); molybdenum (Mo); ruthenium (Ru); or cobalt (Co), with or without an adhesion liner, e.g., titanium nitride (TiN).

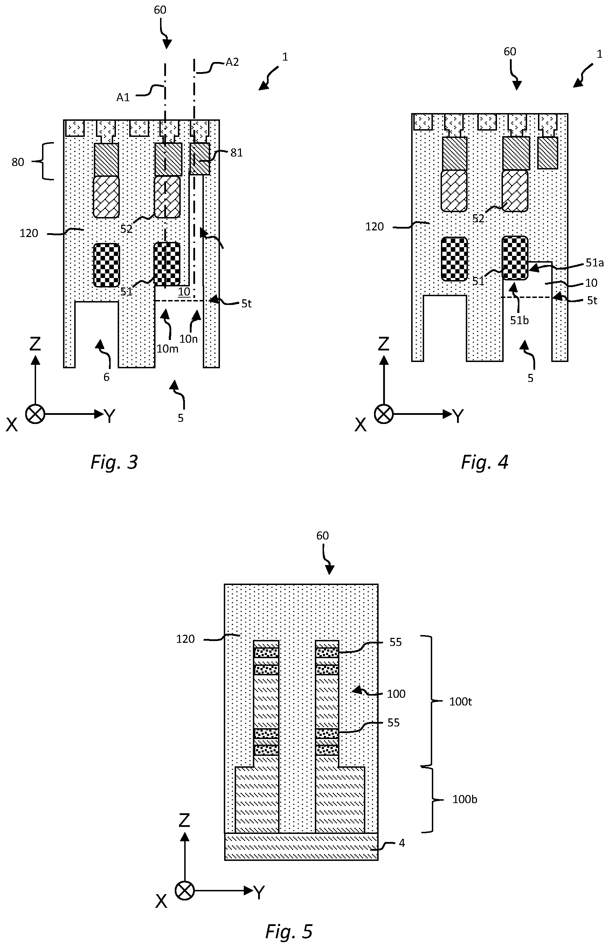

Fig. 3 shows a cross-sectional view of the integrated circuit device 1 taken along vertical plane B-B' indicated in Fig. 1b. Fig. 3 is the same as Fig. 2c and illustrate further that the first hole 10 may be configured
such that a first side portion 10m of the first hole 10 is arranged on a same vertical axis A1 as the first source/drain region 51 of the bottom FET 61 and the first source/drain region 52 of the top FET 62; and
such that a second side portion 10n of the first hole 10 is arranged on a vertical axis A2 laterally spaced apart from the first source/drain region 52 of the top FET 62.

Fig. 4 shows a cross-sectional view of an integrated circuit device 1 wherein the first hole 10:
exposes a bottom side 51b of the first source/drain region 51 of the bottom FET 61 of the first stack of FETs 60; and
exposes a lateral side 51a of the first source/drain region 51 of the bottom FET 61 of the first stack of FETs 60.

Fig. 5 shows a cross-sectional view of an integrated circuit device 1 before etching the trenches 5, 6, wherein the cross-section is a cross-section through the channel layers 55. Fig. 5 shows a fin 100, the fin 100 comprising a bottom portion 100b and a top portion 100t, wherein channel layers 55 of the bottom 61 and top 62 FETs of the first stack of FETs 60 are arranged in the top portion 100t of the fin. The first trench 5 may then be formed by etching the bottom portion 100b of the fin 100. This, facilitates self-alignment of the first trench 5 (later to become the first backside wiring line 71) and the first stack of FETs 60.

Fig. 5 further shows the fin 100 being arranged on a substrate 4. Etching the trenches 5, 6 may be performed after thinning at least part of the substrate 4 from the bottom side bottom side of the substrate 4.

Fig. 5 further shows the fin 100 being formed such that the bottom portion 100b of the fin 100 is wider than the top portion 100t of the fin 100. Thus, by etching away the bottom portion 100b of the fin 100 a trench 5 that is wider than the channel layers 55 may be formed.

As mentioned above, trenches and holes may be formed by etching. Etching may be performed by dry etching, e.g. by plasma etching. Alternatively or additionally, etching may be performed by wet etching. Some trenches or holes (e.g. the first 5 and/or second 6 trench) may be etched by selective etching of the fin by an etchant that does not significantly etch the device isolation layer 120.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming an integrated circuit device (1), the method comprising:
forming a stack of field effect transistors (60), FETs, the stack of FETs (60) comprising a bottom FET (61) and a top FET (62), the bottom FET (61) comprising at least a first source/drain region (51), the top FET (62) comprising at least a first source/drain region (52) arranged above the first source/drain region (51) of the bottom FET (61);
forming a first trench (5) underneath the bottom FET (61);
forming a first hole (10), extending between a top portion (5t) of the first trench (5) and the first source/drain region (51) of the bottom FET (61);
forming a second hole (20), the second hole (20) extending between a top portion (10t) of the first hole (10) and a contact (81) of a contact layer (80) and being laterally spaced apart from the first source/drain region (52) of the top FET (62), the contact layer (80) being arranged above the top FET (62);
performing a first metal deposition to fill the first hole (10); the second hole (20); and at least part of the first trench (5), with metal;
recessing the metal deposited in the first metal deposition, the recessed metal forming an electrical connection (90) extending between the first source/drain region (51) of the bottom FET (61) and the contact (81) of the contact layer (80), a bottom portion (90b) of the recessed metal being arranged within the first hole (10);
forming an isolation layer (92) below the bottom portion (90b) of the recessed metal;
performing a second metal deposition to fill the first trench (5) with metal, such that the metal of the second metal deposition forms a first backside wiring line (71) in the first trench (5), the first backside wiring line (71) being electrically isolated from the electrical connection (90) extending between the first source/drain region (51) of the bottom FET (61) and the contact (81) of the contact layer (80), by the isolation layer (92).

2. The method according to claim 1, wherein the first hole (10) is self-aligned with the first trench (5).

3. The method according to claim 1 or 2,
wherein a first side portion (10m) of the first hole (10) is arranged on a same vertical axis (A1) as the first source/drain region (51) of the bottom FET (61) and the first source/drain region (52) of the top FET (62); and
wherein a second side portion (10n) of the first hole (10) is arranged on a vertical axis (A2) laterally spaced apart from the first source/drain region (52) of the top FET (62).

4. The method according to claim 3, wherein the second hole (20) is formed at the second side portion (10n) of the first hole (10).

5. The method according to any one of the preceding claims, wherein the first hole (10):
exposes at least part of a bottom side (51b) of the first source/drain region (51) of the bottom FET (61); and
exposes at least part of a lateral side (51a) of the first source/drain region (51) of the bottom FET (61).

6. The method according to any one of the preceding claims, wherein said act of forming the isolation layer (92) on the bottom portion of the recessed metal is performed by conformal deposition.

7. The method according to any one of the preceding claims, wherein said act of forming the stack of FETs (60) comprises forming a fin (100), the fin (100) comprising a bottom portion (100b) and a top portion (100t), wherein channel layers (55) of the bottom (61) and top (62) FETs are arranged in the top portion (100t) of the fin.

8. The method according to claim 7, wherein the first trench (5) is formed by etching the bottom portion (100b) of the fin (100).

9. The method according to claim 7 or 8, wherein the fin (100) is formed such that the bottom portion (100b) of the fin (100) is wider than the top portion (100t) of the fin (100).

10. The method according to any one of the preceding claims, further comprising
forming a FET (61") laterally spaced apart from the bottom FET (61), at a same height as the bottom FET (61);
forming a second backside wiring line (72) in electrical connection with a source/drain region (51") of the FET (61") laterally spaced apart from the bottom FET (61).

11. The method according to claim 10, wherein said act of forming the second backside wiring line (72) comprises:
forming a second trench (6) underneath the FET (63) laterally spaced apart from the bottom FET (61);
forming a third hole (30), extending between a top portion (6t) of the second trench (6) and the source/drain region (51") of the FET (61") laterally spaced apart from the bottom FET (61);
performing metal deposition to fill the third hole (30); and at least part of the second trench (6), with metal.

12. An integrated circuit device (1), the integrated circuit device (1) comprising:
a stack of field effect transistors (60), FETs, the stack of FETs comprising a bottom FET (61) and a top FET (62), the bottom FET (61) comprising at least a first source/drain region (51), the top FET (62) comprising at least a first source/drain region (52) arranged above the first source/drain region (51) of the bottom FET (61);
a first trench (5) underneath the bottom FET (61), the first trench (5) being filled with metal to form a first backside wiring line (71);
a first hole (10), extending between a top portion (5t) of the first trench (5) and the first source/drain region (51) of the bottom FET (61);
a second hole (20), the second hole (20) extending between a top portion (10t) of the first hole (10) and a contact (81) of a contact layer (80) and being laterally spaced apart from the first source/drain region (52) of the top FET (62), the contact layer (80) being arranged above the top FET (62);
an electrical connection (90) between the first source/drain region (51) of the bottom FET (61) and the contact (81) of the contact layer (80), the electrical connection (90) comprising metal arranged to fill the second hole (20) and at least part of the first hole (10), the metal of the electrical connection (90) extending from the contact (81) of the contact layer (80) to an isolation layer (92);
wherein the first backside wiring line (71) is electrically isolated from the electrical connection (90) between the first source/drain region (51) of the bottom FET (61) and the contact (81) of the contact layer (80), by the isolation layer (92);
wherein the first hole (10) is self-aligned with the first trench (5).

13. The integrated circuit device (1) according to claim 12,
wherein a first side portion (10m) of the first hole (10) is arranged on a same vertical axis (A1) as the first source/drain region (51) of the bottom FET (61) and the first source/drain region (52) of the top FET (62); and
wherein a second side portion (10n) of the first hole (10) is arranged on a vertical axis (A2) laterally spaced apart from the first source/drain region (52) of the top FET (62).

14. The integrated circuit device (1) according to claim 13, wherein the second hole (20) is arranged at the second side portion (10n) of the first hole (10).

15. The integrated circuit device (1) according to any one of claims 12-14, wherein the first hole (10):
exposes at least part of a bottom side (51b) of the first source/drain region (51) of the bottom FET (61); and
exposes at least part of a lateral side (51a) of the first source/drain region (51) of the bottom FET (61).
